# EUROPÄISCHE PATENTSCHRIFT

(11) **EP 1 873 879 B1**
(45) Veröffentlichungstag und Bekanntmachung des Hinweises auf die Patenterteilung: **08.02.2012**
(21) Anmeldenummer: 07011919.3
(22) Anmeldetag: 18.06.2007
(51) Int. Cl.: H01S 5/323, H01S 5/02, H01S 5/22, H01S 5/32

(54) **Kantenemittierender Halbleiterlaser**
Edge-emitting semiconductor laser
Laser semi-conducteur à émission latérale

(30) Priorität: 30.06.2006 DE 102006030251; 20.12.2006 DE 102006060410
(43) Veröffentlichungstag der Anmeldung: 02.01.2008
(73) Patentinhaber: OSRAM Opto Semiconductors GmbH, 93055 Regensburg (DE)
(72) Erfinder: Eichler, Christoph, Dr., 93105 Tegernheim (DE); Härle, Volker, Dr., 93164 Laaber (DE); Rumbolz, Christian, 93138 Lappersdorf (DE); Strauss, Uwe, Dr., 93077 Bad Abbach (DE)
(74) Vertreter: Epping - Hermann - Fischer

(56) Entgegenhaltungen:
- EP-A- 1 460 741
- WO-A-2005/004231
- JP-A- 2000 106 473
- US-A1- 2004 033 638
- US-A1- 2005 104 083
- US-A1- 2006 121 702
- US-B1- 6 562 648
- NAKAMURA S ET AL: "HIGH-POWER, LONG-LIFETIME INGAN/GAN/ALGAN-BASED LASER DIODES GROWN ON PURE GAN SUBSTRATES" JAPANESE JOURNAL OF APPLIED PHYSICS, JAPAN SOCIETY OF APPLIED PHYSICS, TOKYO, JP, Bd. 37, Nr. 3B, 15. März 1998 (1998-03-15), Seiten L309-L312, XP000824552 ISSN: 0021-4922

## Beschreibung

Es wird ein kantenemittierender Halbleiterlaserchip angegeben.

In der Druckschrift US 6,562,648 B1 ist eine Methode zur Separation und zum Transfer von Halbleiterfilmen angegeben.

Die Druckschrift US 2004/0033638 A1 betrifft eine Herstellungsmethode für eine auf GaN basierende Halbleiterkomponente.

Ein Verfahren zur Herstellung eines Strahlung emittierenden Halbleiterchips ist in der Druckschrift US 2005/0104083 A1 beschrieben.

In der Druckschrift EP 1 460 741 A1 ist eine Laserdiode offenbart.

Eine zu lösende Aufgabe besteht darin, einen verbesserten kantenemittierenden Halbleiterlaserchip anzugeben. Eine weitere zu lösende Aufgabe besteht darin, die Verspannungen und die Wellenführung in einem Halbleiterlaser zu optimieren.

Anspruch 1 kennzeichnet die Erfindung, die abhängigen Ansprüche vorteilhafte Ausbildungen.

Der Begriff Abwandlung bezeichnet im Folgenden Beispiele zum besseren Verständnis der Erfindung.

Der kantenemittierende Halbleiterlaserchip umfasst ein Trägersubstrat.

Der kantenemittierende Halbleiterlaserchip umfasst ferner eine erste Zwischenschicht, die eine Haftung zwischen dem Trägersubstrat und einer Bauelementstruktur des kantenemittierenden Halbleiterlaserchips vermittelt.

In einer Abwandlung ist das Trägersubstrat mittels der Zwischenschicht an einer Nutzschicht aus Halbleitermaterial mechanisch befestigt. Die Nutzschicht zeichnet sich vorzugsweise durch eine geringe Versetzungsdichte aus. Die dem Trägersubstrat abgewandte Oberfläche der Halbleiterschicht dient dann als Aufwachsfläche für epitaktisch hergestellte Halbleiterschichten - zum Beispiel die Bauelementstruktur des kantenemittierenden Halbleiterlaserchips. Weiter ist es möglich, dass das Trägersubstrat mittels der Zwischenschicht direkt auf die epitaktisch gewachsene Bauelementstruktur des kantenemittierenden Halbleiterlaserchips gebondet ist.

Die Bauelementstruktur umfasst eine aktive Zone, die zur Strahlungserzeugung vorgesehen ist. Das heißt, bei Bestromen des kantenemittierenden Halbleiterlaserchips wird in dieser aktiven Zone elektromagnetische Strahlung erzeugt und/oder verstärkt, welche dann als Laserstrahlung den kantenemittierenden Halbleiterlaserchip verlässt.

Es umfasst der kantenemittierende Halbleiterlaserchip also ein Trägersubstrat und eine Zwischenschicht, die eine Haftung zwischen dem Trägersubstrat und einer Bauelementstruktur des kantenemittierenden Halbleiterlaserchips vermittelt, wobei die Bauelementstruktur eine aktive Zone umfasst, die zur Strahlungserzeugung vorgesehen ist.

Es bildet die Zwischenschicht eine Mantelschicht des kantenemittierenden Halbleiterlaserchips. Dazu weist die Zwischenschicht beispielsweise einen deutlich geringeren Brechungsindex als das sie umgebende Halbleitermaterial auf. Aufgrund des geringen Brechungsindizes der Zwischenschicht wird die im Halbleiterlaserchip erzeugte optische Welle vom Trägersubstrat sowie von Schichten, die zwischen Trägersubstrat und Zwischenschicht liegen, abgeschirmt, wodurch so genannte Substratmoden - das heißt das Eindringen der optischen Welle in das Substrat - wirkungsvoll verhindert wird. Dadurch, dass die Zwischenschicht einen Teil der Mantelschicht des kantenemittierenden Halbleiterlaserchips bildet, kann die Dicke einer epitaktisch gewachsenen Mantelschicht verringert werden.

Beispielsweise bei Nitrid-basierten Laserdioden werden die Materialien InGaN - aktive Zone -, GaN - Wellenleiter, Kontaktschicht, Substrat - und AlGaN - Mantelschichten (so genannte Claddingschichten) - verwendet, die im unverspannten Fall eine unterschiedliche Gitterkonstante haben. Dies resultiert in Verspannungen im Schichtsystem, die die Lasereigenschaften und möglichen Wachstumsparameter beschränkten. Je weiter die Emissionswellenlänge von etwa 405 nm, - das heißt wenig Indium und wenig Aluminium - in Richtung blau beziehungsweise grün verschoben wird, desto mehr Indium wird in der aktiven Zone benötigt, um die Emissionswellenlänge einzustellen. Da mit größer werdender Wellenlänge aber auch der Brechungsindexkontrast zwischen GaN und AlGaN abnimmt, wird für eine vergleichbar gute Wellenführung gleichzeitig ein höherer Aluminiumanteil und/oder eine größere Schichtdicke benötigt. Damit vergrößert sich die Gitterfehlanpassung zwischen AlGaN-Mantelschicht und aktiver Zone - InGaN - zunehmend mit längerer Wellenlänge, wodurch sich starke Verspannungen im Material bilden, die die Materialqualität begrenzen. Die gleiche Problematik ergibt sich analog auch für kurzwellige Laser mit einer Emissionswellenlänge < 405 nm. Insbesondere für Wellenlängen < 360 nm gilt darüber hinaus, dass in der Laserstruktur enthaltenes GaN in diesem Wellenlängenbereich stark absorbiert. Daher werden zur Erreichung hoher Lebensdauern defektreduzierte AlGaN-Substrate benötigt. Eine Möglichkeit besteht darin, die Laserdioden auf defektreduziertem GaN zu wachsen, wobei dieses im Hinblick auf die Gitterkonstante vor allem für geringe aluminium- und indiumhaltige Schichten geeignet ist. Zur Reduzierung der Substratmode eignen sich dicke Mantelschichten besonders gut. Bei langen Wellenlängen nimmt die benötigte Manteldicke stark zu und der Füllfaktor in der aktiven Zone ab.

Der hier beschriebene kantenemittierende Halbleiterlaserchip ermöglicht unter anderem eine gezielte Einstellung der Substrat-Gitterkonstante. Ferner ermöglicht der kantenemittierende Halbleiterlaserchip unter anderem für gitterangepasste Epitaxie auf defektarmen Substraten erstmals eine Reduktion der benötigten Manteldicke und einen erhöhten Füllfaktor in der aktiven Zone bei gleichzeitig verbessertem Verspannungshaushalt der aktiven Zone.

Es bildet die Zwischenschicht eine Mantelschicht des kantenemittierenden Halbleiterlaserchips. Es ist auf eine epitaktisch gewachsene Mantelschicht auf der Seite der aktiven Zone, die der ersten Zwischenschicht zugewandt ist, vollständig verzichtet. Die Zwischenschicht übernimmt hier die Aufgabe der Mantelschicht. Durch den vorzugsweise starken Brechungsindexsprung zwischen der Zwischenschicht und dem Wellenleiter des Halbleiterlasers, der der Zwischenschicht zugewandt ist, wird die im Halbleiterlaser erzeugte optische Welle sehr stark geführt, wodurch vorteilhaft der Füllfaktor in der aktiven Zone erhöht werden kann.

Es ist die erste Zwischenschicht elektrisch isolierend. Die erste Zwischenschicht enthält dabei vorzugsweise ein Siliziumnitrid und/oder ein Siliziumoxid. Die Zwischenschicht kann dabei beispielsweise eines der folgenden Materialien enthalten oder aus einem der folgenden Materialien bestehen: SiO₂, Si₃N₄.

In einer Abwandlung des kantenemittierenden Halbleiterlaserchips vermittelt die Zwischenschicht einen elektrischen Kontakt zwischen dem Trägersubstrat und der aktiven Zone. Das heißt die Zwischenschicht ist elektrisch leitfähig. Über die Zwischenschicht wird beispielsweise p-seitig ein elektrischer Strom in die aktive Zone des kantenemittierenden Halbleiterlaserchips eingeprägt. Beispielsweise kann die Zwischenschicht in diesem Fall aus einem transparenten leitfähigen Oxid (TCO - transparent conductive oxide) wie zum Beispiel ITO gebildet sein oder dieses Material enthalten.

In einer Abwandlung des kantenemittierenden Halbleiterlaserchips vermittelt die Zwischenschicht eine Haftung zwischen dem Trägersubstrat und einer Nutzschicht, wobei auf die der Zwischenschicht abgewandten Seite der Nutzschicht zumindest ein Teil der Bauelementstruktur epitaktisch abgeschieden ist. Bei dem Trägersubstrat kann es sich dabei zum Beispiel um ein kostengünstiges weil defektreiches GaN-Trägersubstrat handeln. Das Trägersubstrat ist mittels der Zwischenschicht mit der Nutzschicht verbunden, bei der es sich beispielsweise um eine defekt- und versetzungsarme epitaktisch gewachsene Schichtenfolge handeln kann. Zumindest ein Teil der Bauelementstruktur wird epitaktisch auf diese Nutzschicht abgeschieden, welche dann selbst funktionelle Aufgaben im kantenemittierenden Halbleiterlaserchip übernehmen kann.

In einer Abwandlung des kantenemittierenden Halbleiterlaserchips bildet die Nutzschicht zumindest einen Teil einer Mantelschicht oder einer Wellenleiterschicht des kantenemittierenden Halbleiterlaserchips. Das bedeutet, die Nutzschicht übernimmt im kantenemittierenden Halbleiterlaserchip die Aufgabe einer Mantelschicht oder einer Wellenleiterschicht. Diese Schichten oder zumindest Teile dieser Schichten sind dann nicht gemeinsam epitaktisch mit den übrigen Schichten der Bauelementstruktur hergestellt, sondern auf diese Schichten ist die Bauelementstruktur aufgebracht, beispielsweise epitaktisch abgeschieden.

Es ist die Zwischenschicht eine Bondschicht. Das heißt die Zwischenschicht dient zum Bonden des Trägersubstrats an die Nutzschicht oder direkt an die Bauelementstruktur. Beispielsweise enthält oder besteht die erste Zwischenschicht dazu aus zumindest einem der folgenden Materialien: SiO₂, Si₃N₄, SiN, AL₂O₃.

In einer Abwandlung des kantenemittierenden Halbleiterlaserchips ist der Brechungsindex des Materials, aus dem die Zwischenschicht gebildet ist, kleiner als der Brechungsindex des Materials, aus dem die Nutzschicht gebildet ist. Auf diese Weise kommt es zwischen Nutzschicht und Zwischenschicht zu einem Brechungsindexsprung, der, wie weiter oben beschrieben, ein Eindringen der im Halbleiterlaserchip erzeugten optischen Welle in das Trägersubstrat ganz oder zumindest teilweise verhindern kann. Es umfasst der kantenemittierende Halbleiterlaserchip neben der ersten Zwischenschicht eine zweite Zwischenschicht, wobei die aktive Zone zwischen den beiden Zwischenschichten angeordnet ist. Das heißt sowohl an der n-Seite als auch an der p-Seite des kantenemittierenden Halbleiterlaserchips ist eine Zwischenschicht angeordnet, wobei die Zwischenschichten je eine Bondschicht bilden. Es ist die zweite Zwischenschicht in diesem Fall elektrisch leitfähig und dient zum n-seitigen beziehungsweise p-seitigen Einprägen eines Stroms in die aktive Zone.

In einer Abwandlung des kantenemittierenden Halbleiterlaserchips ist zwischen der Zwischenschicht und der Nutzschicht beziehungsweise zwischen der Zwischenschicht und der Bauelementstruktur teilweise ein Material angeordnet, das elektrisch isolierend ist und/oder einen kleineren Brechungsindex als die Zwischenschicht aufweist. Auf diese Weise ist beispielsweise ein indexgeführter kantenemittierender Halbleiterlaserchip realisiert.

Der hier beschriebene kantenemittierende Halbleiterlaser macht sich mit anderen Worten unter anderem die folgenden Überlegungen zu nutze: In die Laserstruktur wird eine Zwischenschicht mit niedrigem Brechungsindex eingefügt, z.B. SiO₂, Si₃N₄, ITO. Gleichzeitig wird die Defektdichte der Epitaxieschichten gering gehalten. Dazu wird zum Beispiel die Laserstruktur auf eine Nutzschicht mit geringer Versetzungsdichte aufgewachsen, welches durch einen Lateral Cleave Prozess hergestellt wird. Dabei wird zum Bonden der Nutzschicht auf den Träger die Zwischenschicht mit deutlich geringerem Brechungsindex als GaN - zum Beispiel SiO₂, SiN, Si₃N₄, ITO - verwendet, welches im kantenemittierenden Halbleiterlaserchip gleichzeitig als Mantelschicht oder zumindest als Teil desselben wirkt. Aufgrund des geringen Brechungsindexes der Zwischenschicht wird dabei die optische Welle vom darunter liegenden Material - das heißt zum Beispiel dem Trägersubstrat - abgeschirmt, wodurch eine Substratmode wirkungsvoll verhindert wird. Die verbleibende Manteldicke direkt über der Zwischenschicht kann dabei so gewählt werden, dass ein Optimum zwischen optischen und elektrischen Eigenschaften eingestellt wird. So kann zum Beispiel für bessere Querleitfähigkeit eine gewisse Manteldicke über der Zwischenschicht stehen bleiben. Für den Fall eines vertikalen Stromtransports durch das Bauelement zum Beispiel mit einer ITO-Zwischenschicht kann eine Rest-Mantelschichtdicke verwendet werden um mögliche Absorptionen an der Zwischenschicht zu verhindern. Die Rest-Mantelschicht kann aber auch ganz weggelassen werden. In diesem Fall wirkt die Zwischenschicht direkt als Mantelschicht, wobei die optische Welle auf Grund des starken Brechungsindexsprungs zum Wellenleiter sehr stark geführt wird, wodurch der Füllfaktor in der aktiven Zone erhöht werden kann. Durch die verschiedenen möglichen Manteldicken kann dabei die Verspannung in der aktiven Zone gezielt eingestellt werden, zum Beispiel kann die Verspannung ohne AlGaN-Mantelschicht auf relaxiertes GaN eingestellt werden. Für UV-Laser kann dementsprechend ein relaxiertes AlGaN-Substrat hergestellt werden, beziehungsweise für langwellige Laser ein indiumhaltiges Substrat.

Das Optimum zwischen optischen Eigenschaften und guter Bondbarkeit kann darüber hinaus durch Verwendung mehrerer Schichten - zum Beispiel dünnes SiO₂ für gute Bondbarkeit an der Halbleitergrenzfläche, gefolgt von einem Siliziumnitrid mit höherem Brechungsindex für angepasste Wellenführung - eingestellt werden.

Im Folgenden werden einzelne Aspekte des hier beschriebenen kantenemittierenden Halbleiterlaserchips anhand von Abwandlungen und den dazugehörigen Figuren näher erläutert.
- Figur 1A: zeigt eine schematische Schnittdarstellung eines kantenemittierenden Halbleiterlaserchips gemäß einer ersten Abwandlung.
- Figur 1B: zeigt eine schematische Schnittdarstellung eines kantenemittierenden Halbleiterlaserchips gemäß einer zweiten Abwandlung.
- Figur 1C: zeigt eine schematische Schnittdarstellung eines kantenemittierenden Halbleiterlaserchips gemäß einer dritten Abwandlung.
- Figur 2A: zeigt eine schematische Schnittdarstellung eines kantenemittierenden Halbleiterlaserchips gemäß einer vierten Abwandlung.
- Figur 2B: zeigt eine schematische Schnittdarstellung eines kantenemittierenden Halbleiterlaserchips gemäß einer fünften Abwandlung.
- Figur 2C: zeigt eine schematische Schnittdarstellung eines kantenemittierenden Halbleiterlaserchips gemäß einer sechsten Abwandlung.
- Figur 3A: zeigt eine schematische Schnittdarstellung eines kantenemittierenden Halbleiterlaserchips gemäß einer siebten Abwandlung.
- Figur 3B: zeigt eine schematische Schnittdarstellung eines kantenemittierenden Halbleiterlaserchips gemäß eines Ausführungsbeispiels .
- Figur 4A: zeigt eine schematische Schnittdarstellung eines kantenemittierenden Halbleiterlaserchips, bei dem die elektromagnetische Strahlung in das Substrat gedrückt wird.
- Figur 4B: zeigt in einer Auftragung die benötigte Dicke der Claddingschicht aufgetragen gegen die Wellenlänge der in der aktiven Zone des Lasers erzeugten elektromagnetischen Strahlung um Substrat-Moden zu unterdrücken.
- Figur 4C: zeigt das elektrische Feld neben dem Ridge des Lasers der Figur 4A.
- Figur 5A: zeigt in einer Auftragung den Füllfaktor der Laserstruktur aufgetragen gegen die Wellenlänge der in der aktiven Zone des Lasers erzeugten elektromagnetischen Strahlung.
- Figuren 5B und 5C: zeigen das elektrische Feld analog zur Figur 4C bei 400 nm beziehungsweise bei 470 nm.
- Figur 6A: zeigt das elektrische Feld bei einem Laser wie er in der Figur 4A gezeigt ist, mit einem Füllfaktor von 1,94 %.
- Figur 6B: zeigt das elektrische Feld bei einem Laser wie er in Verbindung mit einer der Figur 1, 2 oder 3 beschrieben ist, mit einem Füllfaktor von 2,23 %.

In den Abwandlungen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

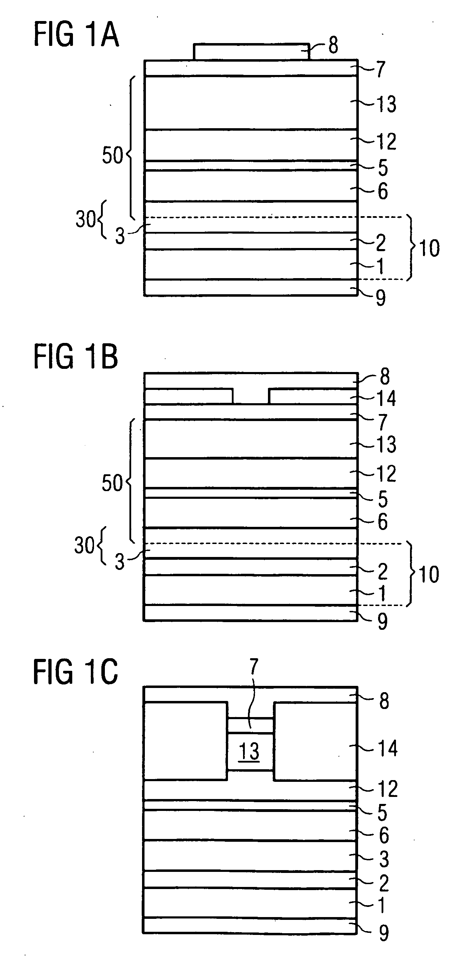

Die Figur 1A zeigt eine schematische Schnittdarstellung eines kantenemittierenden Halbleiterlaserchips gemäß einer ersten Abwandlung.

Beim kantenemittierenden Halbleiterlaserchip gemäß der Abwandlung der Figur 1A handelt es sich um einen Breitstreifenlaser. Der Halbleiterlaserchip umfasst ein Trägersubstrat 1. Bei dem Trägersubstrat 1 handelt es sich in der vorliegenden Abwandlung um ein kostengünstiges, defektreiches GaN-Trägersubstrat.

Der Halbleiterlaserchip umfasst ferner eine Zwischenschicht 2. Bei der Zwischenschicht 2 handelt es sich um eine Bondschicht, die eine mechanische Verbindung zwischen dem Trägersubstrat 1 und einer Nutzschicht 3 vermittelt. Bei der Nutzschicht 3 handelt es sich zum Beispiel um eine epitaktisch gewachsene Schicht, die InGaN enthält oder aus diesem besteht. Zur Herstellung wird dazu beispielsweise zuerst auf einem hochwertigen, versetzungsarmen, teuren GaN-Muttersubstrat eine verspannte Epitaxieschicht aus oder mit InGaN abgeschieden. Anschließend wird die Zwischenschicht 2 auf die der Muttersubstrat abgewandte Seite der Epitaxieschicht aufgebracht. Durch einen so genannten "lateral cleave"-Prozesses - beispielsweise durch Implantation von Wasserstoff - wird die Epitaxieschicht nachfolgend vom Muttersubstrat abgelöst und bildet die Nutzschicht 3. Ein solches Verfahren zur Herstellung eines Quasi-Substrats mit Nutzschicht ist zum Beispiel in der Druckschrift WO 2005/004231 beschrieben, deren Offenbarungsgehalt diesbezüglich hiermit ausdrücklich durch Rückbezug aufgenommen wird.

Bei der in Verbindung mit der Figur 1A beschriebenen Abwandlung ist die Zwischenschicht 2 elektrisch leitfähig und besteht oder enthält zum Beispiel ITO.

Auf der Nutzschicht 3 ist die Bauelementstruktur 50 des Halbleiterlasers epitaktisch abgeschieden. Die Bauelementstruktur 50 umfasst beispielsweise eine n-seitige Wellenleiterschicht 6, eine aktive Zone 5, welche Einfach- oder Mehrfachquantentopfstrukturen, Barriereschichten sowie Spacerschichten enthalten kann, welche auf die n-seitige Wellenleiterschicht 6 aufgebracht ist.

Auf die der n-seitigen Wellenleiterschicht 6 abgewandte Seite der aktiven Zone 5 ist eine p-seitige Wellenleiterschicht 12 abgeschieden. Der p-seitigen Wellenleiterschicht 12 folgt in Wachstumsrichtung eine p-seitige Mantelschicht 13 nach. Auf die p-seitige Mantelschicht 13 ist eine p-seitige Kontaktschicht 7 epitaktisch aufgewachsen oder aufgebracht. Ferner weist der kantenemittierende Halbleiterlaserchip einen p-Kontakt 8 und einen n-Kontakt 9 auf.

Zwischen der n-seitigen Wellenleiterschicht 6 und der Nutzschicht 3 kann - wie in Figur 1A gezeigt - ein Material epitaktisch abgeschieden werden, das in seiner Zusammensetzung der Nutzschicht 3 entspricht. Die derart erzeugte Schicht bildet zusammen mit der Nutzschicht 3 die n-seitige Mantelschicht 30 oder ein Teil dieser Mantelschicht.

Es ist aber auch möglich, dass die n-seitige Wellenleiterschicht 6 direkt auf die Nutzschicht 3 epitaxiert wird. In diesem Fall bildet die Nutzschicht 3 die n-seitige Mantelschicht 30 oder zumindest einen Teil der n-seitigen Mantelschicht.

Für relativ langwellige - beispielsweise grüne - Laserstrahlung kann die Zwischenschicht 2 einen Teil der n-seitigen Mantelschicht bilden. Auf diese Weise kann die epitaktisch gewachsene n-seitige Mantelschicht möglichst dünn und damit möglichst defektarm gehalten werden.

Bei der Herstellung des in Verbindung mit der Figur 1A beschriebenen kantenemittierenden Halbleiterlaserchips kann nach der Epitaxie der Schichtenfolge die Chipprozessierung durchgeführt werden. Bei fehlender Kristallorientierung zwischen den Epitaxieschichten der Bauelementstruktur 50 und dem Trägersubstrat 1 ist es erforderlich, die Laserfacetten durch einen trockenchemischen Ätzprozess zu erzeugen. Vorteil dieses Verfahrens ist es, dass fertig prozessierte Bauteile im Waferverbund vorliegen und noch im Waferverbund getestet werden können.

Eine weitere Methode zur Erzeugung der Laserfacetten besteht darin, dass beispielsweise die Zwischenschicht 2 gezielt unterätzt wird. Auf diese Weise kann ein Überstand erzeugt werden, und die epitaktisch aufgewachsenen Schichten der Bauelementstruktur 50 können gebrochen werden. Die Bruchfläche bildet dann die entsprechenden Laserfacetten des kantenemittierenden Halbleiterlaserchips.

Beim in Verbindung mit der Figur 1A beschriebenen Halbleiterlaserchip handelt es sich um einen Breitstreifenlaser mit einem streifenförmigen p-Kontakt 8.

Bei einer leitfähigen Zwischenschicht 2 - zum Beispiel ITO - kann im Bauteil ein vertikaler Strompfad verwendet werden. Dazu ist es von Vorteil, auf ein leitfähiges Trägersubstrat 1 mit ähnlicher thermischer Ausdehnung wie das Quasisubstrat 3 zu bonden.

Die Figur 1B zeigt eine schematische Schnittdarstellung eines kantenemittierenden Halbleiterlaserchips gemäß einer zweiten Abwandlung. Beim in Verbindung mit der Figur 1B beschriebenen Halbleiterlaserchip handelt es sich um einen Oxidstreifenlaser. Im Unterschied zum in Verbindung mit der Figur 1A beschriebenen Halbleiterlaserchip ist bei diesem Laser ein elektrisch isolierendes, passivierendes Material 14 auf die der aktiven Zone 5 abgewandte Seite der Kontaktschicht 7 aufgebracht. In dem elektrisch passivierenden Material 14 ist eine Öffnung erzeugt, die mit einem p-Kontaktmaterial, das den p-Kontakt 8 bildet, aufgefüllt ist. Auf diese Weise ist ein Oxidstreifenlaser mit p-seitiger Strompfadbegrenzung realisiert.

Die Figur 1C zeigt eine schematische Schnittdarstellung eines kantenemittierenden Halbleiterlaserchips gemäß einer dritten Abwandlung. Im Unterschied zum in Verbindung mit der Figur 1A beschriebenen Halbleiterlaserchip ist bei diesem Halbleiterlaserchip eine Rippenwellenleiterstruktur in die p-seitigen Epitaxie-Schichten der Bauelementstruktur 50 strukturiert, beispielsweise geätzt. Vorzugsweise ist die Rippenwellenleiterstruktur bis zur p-seitigen Wellenleiterschicht 12 geätzt. Auf diese Weise ist ein so genannter "ridge wave guide"-Laser erzeugt. Diese Variante ist für Laser, die neben der hohen n-seitigen Wellenführung auch noch eine starke p-seitige Wellenwirkung und Stromeinprägung benötigen, besonders gut geeignet.

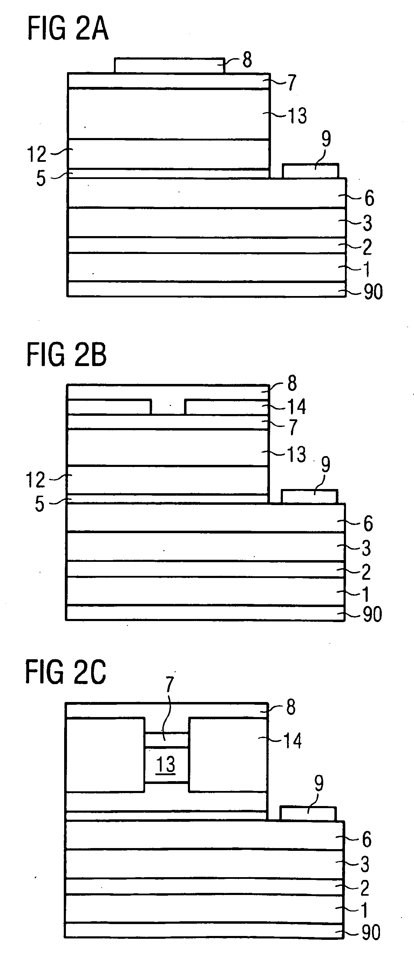

Die Figur 2A zeigt eine schematische Schnittdarstellung eines kantenemittierenden Halbleiterlaserchips gemäß einer vierten Abwandlung. Beim in Verbindung mit der Figur 2A beschriebenen Halbleiterlaserchip ist die Zwischenschicht 2 elektrisch isolierend. Die Zwischenschicht enthält dazu vorzugsweise zumindest ein Siliziumnitrid und/oder ein Siliziumoxid. Beispielsweise ist die Zwischenschicht 2 aus einem der folgenden Materialien gebildet oder enthält zumindest eines der folgenden Materialien: SiO₂, Si₃N₄, SiN.

Bei elektrisch isolierender Zwischenschicht, die zum Beispiel aus einem Siliziumnitrid und/oder aus einem Siliziumoxid besteht, muss der kantenemittierende Halbleiterlaserchip mit n- und p-Kontakt auf der dem Trägersubstrat 1 abgewandten, epitaxierten Seite prozessiert werden, siehe Figuren 2A bis 2C.

Ausgangspunkt für die Epitaxie ist der weiter oben beschriebene lateral cleave Prozess - wie zur Figur 1 beschrieben - zur Erzeugung eines geeigneten Quasi-Substrates mit Nutschicht 3. Die darin aufgebrachte Epitaxiestruktur entspricht der für eine leitfähige Zwischenschicht 2, allerdings muss eine der unteren Mantel- oder Wellenleiterschichten beziehungsweise eine speziell eingeführte Schicht - zum Beispiel GaN/AlGaN-Superlattice -, eine hohe Querleitfähigkeit aufweisen damit der n-Kontakt 9 eine homogene Stromeinprägung in die Diode zulässt. Hierbei kann die niedrigbrechende Zwischenschicht 2 Wellenführungsaufgaben des Mantels übernehmen. Die so prozessierten Laserdioden können wieder in den oben genannten Bauformen Breitstreifenlaser, Figur 2A, Oxidstreifenlaser, Figur 2B und ridge waveguide Laser, Figur 2C ausgeführt werden. Auch hier kann bei nicht angepasster Trägerorientierung das Facettenbrechen durch die oben beschriebenen Ätzschritte ersetzt werden.

Vorteil des hier beschriebenen kantenemittierenden Halbleiterlaserchips ist unter anderem die geringe Epitaxiegesamtschichtdicke, die defektarme, crackfrei, aktive Zone, die im Betrieb nur unter geringer thermischer Belastung steht und weniger Anlagenzeit und Prozessierung ohne Schaden verursachenden Ätzschritten an den Epitaxieschichten während der Herstellung. Durch die starke Wellenführung werden sehr gute Aspektverhältnisse mit großen Öffnungswinkeln möglich.

Im Unterschied zum in Verbindung mit der Figur 1A beschriebenen Halbleiterlaser ist beim in Verbindung mit der Figur 2A beschriebenen kantenemittierenden Halbleiterlaserchip eine Öffnung in der Bauelementstruktur 50 erzeugt, die bis zur n-seitigen Wellenleiterschicht 6 reicht. Auf die stellenweise freigelegte n-seitige Wellenleiterschicht 6 ist ein n-Kontakt 9 aufgebracht. In diesem Fall muss die n-seitige Wellenleiterschicht 6 besonders gut leitfähig sein und vor allem eine hohe Querleitfähigkeit aufweisen, damit eine homogene Stromeinprägung in die aktive Zone 5 mittels des n-Kontakts 9 ermöglicht ist. Alternativ dazu kann zwischen der n-seitigen Wellenschicht 6 und der aktiven Schicht 5 eine spezielle Schicht - zum Beispiel eine GaN/AlGaN-Superlattice-Schicht - eingeführt werden, die eine hohe Querleitfähigkeit aufweist.

Weiter kann die niederbrechende Zwischenschicht 2 zumindest einen Teil der Wellenführungsaufgaben der n-seitigen Mantelschicht 30 übernehmen. Mittels einer Verbindungsschicht 90 - zum Beispiel einer Lotschicht - kann der Halbleiterchip mechanisch auf einem Träger befestigt werden.

Der in Verbindung mit der Figur 2A beschriebene Halbleiterlaserchip bildet einen Breitstreifenlaser, wie er in Verbindung mit der Figur 1A beschrieben ist.

Die Figur 2B zeigt eine schematische Schnittdarstellung eines kantenemittierenden Halbleiterlaserchips gemäß einer fünften Abwandlung. Im Unterschied zur Abwandlung, die in Verbindung mit der Figur 2A beschrieben ist, handelt es sich beim Halbleiterlaserchip der Figur 2B um einen Oxidstreifenlaser, wie er auch in der Figur 1B beschrieben ist.

Die Figur 2C zeigt eine schematische Schnittdarstellung eines kantenemittierenden Halbleiterlaserchips gemäß einer sechsten Abwandlung. Im Unterschied zum in Verbindung mit der Figur 2A beschriebenen Halbleiterlaserchip ist der in Verbindung mit der Figur 2C beschriebene Halbleiterlaserchip als "ridge wave guide"-Laser ausgeführt, wie er schon in Verbindung mit der Figur 1C beschrieben ist.

Sämtliche in Verbindung mit den Figuren 1A, 1B, 1C sowie 2A, 2B und 2C beschriebenen Laserdioden können auch ohne n - Mantelschicht ausgeführt werden. Dabei übernimmt die Zwischenschicht 2 mit einem niedrigeren Brechungsindex als GaN die Aufgaben der n-Mantelschicht.

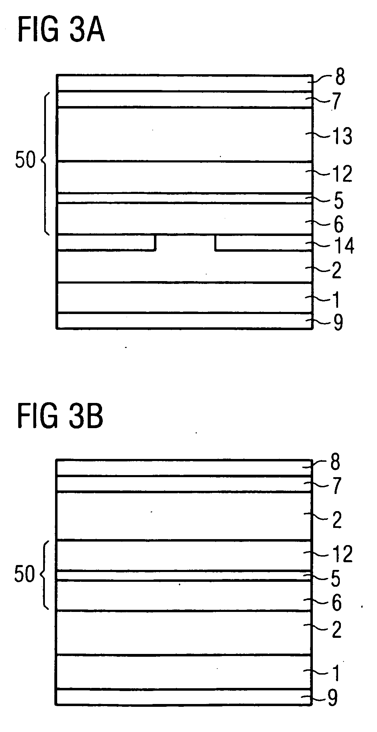

Die Figur 3A zeigt eine schematische Schnittdarstellung eines kantenemittierenden Halbleiterlaserchips gemäß einer siebten Abwandlung. In dieser Abwandlung ist auf die n-Mantelschicht verzichtet. Die Zwischenschicht 2 grenzt direkt an die n-Wellenleiterschicht 6 des kantenemittierenden Halbleiterlasers an. Durch die Verwendung der Zwischenschicht 2 als Mantelschicht ist eine Strukturierung und/oder Passivierung der Mantelschicht möglich. Beispielsweise kann ein passivierendes Material 14 - wie in Figur 3A gezeigt - zumindest stellenweise zwischen Zwischenschicht 2 und n-Wellenleiterschicht 6 eingebracht werden. Bei dem Passivierungsmaterial 14 handelt es sich zum Beispiel um zumindest eines der folgenden Materialien: SiO₂, SiN, Si₃N₄, GaN, AlGaN. Die Schicht aus passivierendem Material 14 liegt besonders nahe an der n-Wellenleiterschicht 6 sowie der aktiven Zone 5 und ermöglicht somit im Zusammenspiel mit der Zwischenschicht 2 ein sehr wirkungsvolles optisches Confinement und eine gezielte Stromeinprägung in die aktive Zone 5. Dabei sind keine Schaden verursachenden Trockenätzschritte an Epitaxieschichten notwendig.

Zur Verwirklichung des Halbleiterlasers, wie er in Verbindung mit der Figur 3A beschrieben ist, wird die Bauelementstruktur 50 auf einem defektarmen Quasi-Substrat, wie es weiter oben beschrieben ist, abgeschieden. Vor dem Aufbringen der Zwischenschicht 2 auf die Bauelementstruktur 50 erfolgt eine Strukturierung der der aktiven Zone 5 abgewandten Seite der n-Wellenleiterschicht 6 mit dem passivierenden und/oder niedrigbrechenden Material 14, in das Kontaktöffnungen geätzt werden. Auf das passivierende Material 14 wird die Zwischenschicht 2 aufgebracht und auf den Träger gebondet. Die nachfolgende Prozessierung beschränkt sich auf das Aufbringen von n-Kontakt 9 und p-Kontakt 8 sowie der Erzeugung der Facetten nach dem weiter oben beschriebenen Verfahren.

Die derart hergestellte Strukturierung ermöglicht ein starkes elektrisches und optisches Confinement. Die hier beschriebene Strukturierung kann auch durch eine p-seitige Strukturierung, wie sie beispielsweise in Verbindung mit den Figuren 1B und 1C beschrieben ist, ergänzt werden.

Die Figur 3B zeigt eine schematische Schnittdarstellung eines kantenemittierenden Halbleiterlaserchips gemäß eines Ausführungsbeispiels . Bei dieser Abwandlung weist der Halbleiterlaser neben der n-seitigen Zwischenschicht 2 auch eine p-seitige Zwischenschicht 2 auf. Die Zwischenschichten 2 können dabei auch als p- und n-seitige Mantelschichten des Halbleiterlasers dienen. Zur Herstellung eines derartigen Halbleiterlasers wird die komplette Laserepitaxie auf defektarmen GaN-Substraten durchgeführt, wobei die p-seitige Mantelschicht ganz oder teilweise weggelassen wird. Nach dem Aufbringen der n-seitigen Zwischenschicht 2 wird auf das Trägersubstrat 1 umgebondet und die Bauelementstruktur 50 vom Aufwachssubstrat abgelöst.

Je nachdem, ob eine leitfähige oder eine elektrisch isolierende n-seitige Zwischenschicht 2 Verwendung findet, erfolgt die Prozessierung analog zu den in Verbindung mit den Figuren 1A, 1B, 1C oder in Verbindung mit den Figuren 2A, 2B, 2C beschriebenen Verfahren.

Weiter ist es möglich, dass eine Strukturierung der p- und/oder n-seitigen Zwischenschichten 2, wie sie in Verbindung mit der Figur 3A beschrieben ist, erfolgt.

Sämtliche in Verbindung mit den Figuren 1A, 1B, 1C, 2A, 2B, 2C, 3A und 3B beschriebenen Anordnungen lassen sich auch mit vertauschter p- und n-Seite der Epitaxieschichten und damit vertauschten p- und n-Kontakten verwirklichen.

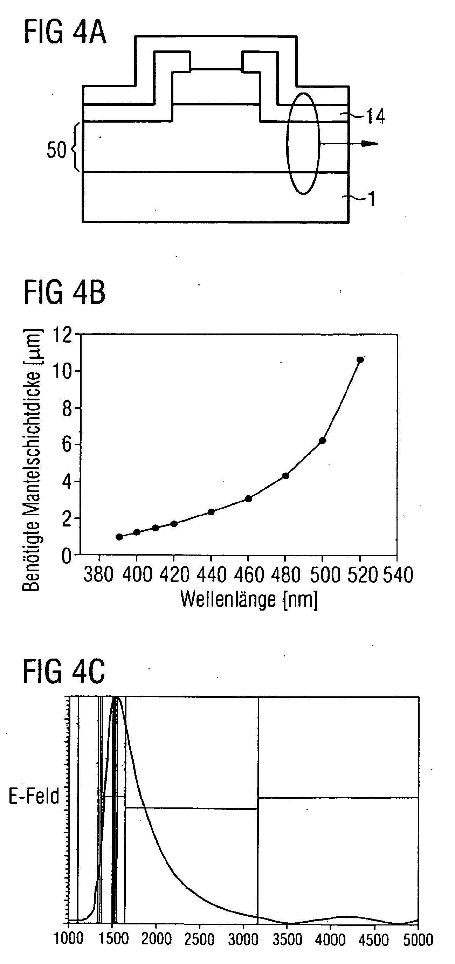

Die Figur 4A zeigt eine schematische Schnittdarstellung eines kantenemittierenden Halbleiterlaserchips, bei dem die elektromagnetische Strahlung - das heißt die optische Welle - 15 in das Substrat 1 gedrückt wird. Der kantenemittierende Halbleiterlaserchip weist hier keine wie weiter oben beschriebene Zwischenschicht auf.

Die Figur 4B zeigt in einer Auftragung die benötigte Dicke der Mantelschicht gegen die Wellenlänge der in der aktiven Zone 5 des Lasers erzeugten elektromagnetischen Strahlung, um Substratmoden zu unterdrücken.

Die Figur 4C zeigt das elektrische Feld in der Nähe des ridges des Lasers der Figur 4A.

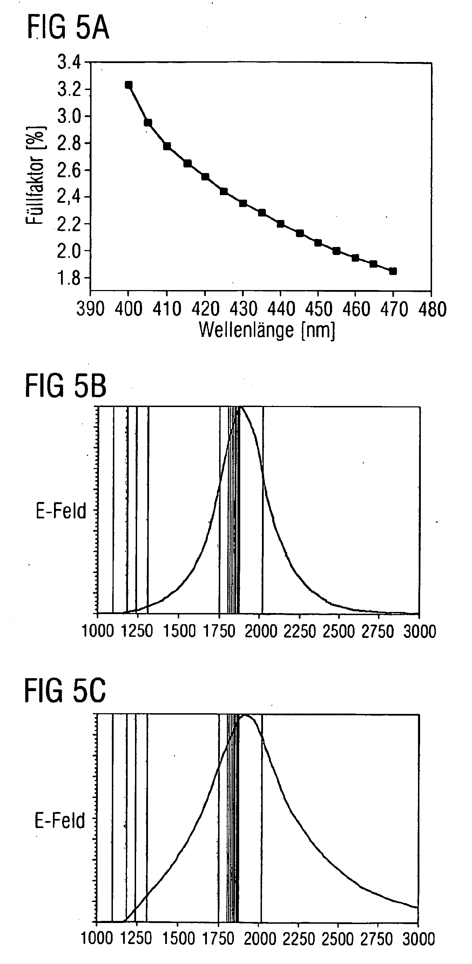

Die Figur 5A zeigt in einer Auftragung den Füllfaktor der Laserstruktur aufgetragen gegen die Wellenlänge der in der aktiven Zone 5 des Lasers erzeugten elektromagnetischen Strahlung. Wie in der Figur 5A dargestellt ist, sinkt der Füllfaktor der Laserstruktur der Figur 4A wegen dem abnehmenden Brechungsindexkontrast mit zunehmender Wellenlänge der elektromagnetischen Strahlung 15.

Die Figuren 5B und 5C zeigen das elektrische Feld analog zur Figur 4C bei einer Wellenlänge der in der aktiven Zone 5 des Lasers erzeugten elektromagnetischen Strahlung 15 von 400 nm beziehungsweise 470 nm.

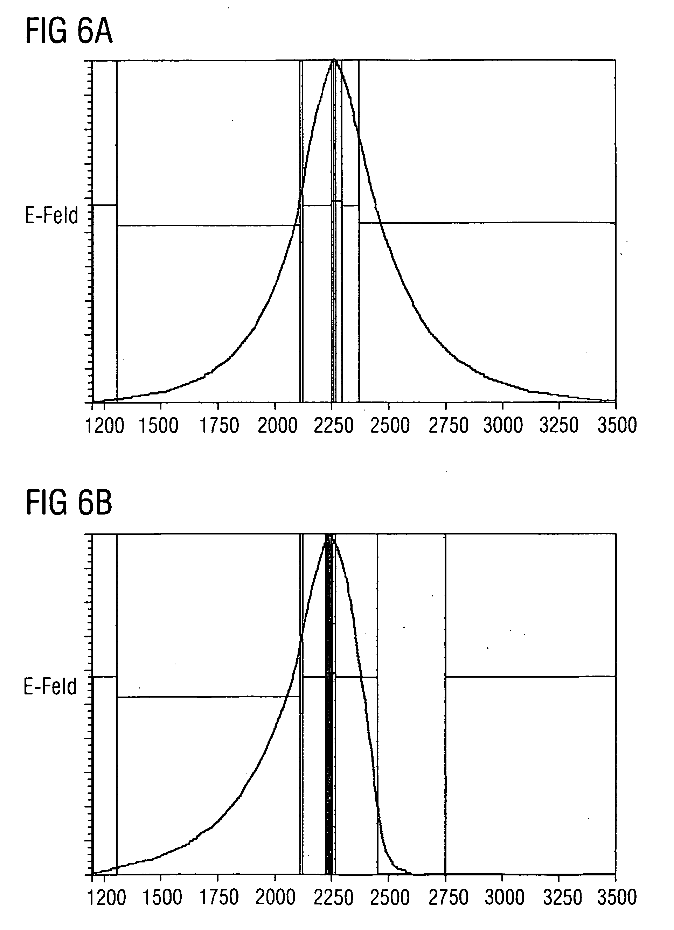

Die Figur 6A zeigt das elektrische Feld bei einem Laser, wie er in der Figur 4A gezeigt ist, mit einem Füllfaktor von 1,94 %. Die Figur 6B zeigt das elektrische Feld bei einem Laser, wie er in Verbindung mit einer der Figuren 2A, 2B oder 3C beschrieben ist. Dabei findet eine SiO₂-Zwischenschicht 2 Verwendung. Der Füllfaktor ist in diesem Fall 2,23 %. Das heißt die optische Welle 15 wird wegen dem großen Brechungsindexsprung an der Zwischenschicht 2 stärker geführt. Aufgrund der Zwischenschicht 2 verbessert sich der Füllfaktor des Lasers also um zirka 15 % gegenüber dem in Verbindung mit der Figur 4A beschriebenen Lasers ohne Zwischenschicht 2.

Insgesamt ergibt sich aus dem in Verbindung mit den Figuren 4A, 4B, 4C, 5A, 5B, 5C, 6A, 6B angestellten Überlegungen, dass eine Zwischenschicht 2 aus einem niederbrechenden Material, die die Wellenleiteraufgaben einer Mantelschicht zumindest teilweise übernimmt, dass der Füllfaktor der aktiven Zone stark verbessert werden kann.

## Patentansprüche

1. Kantenemittierender Halbleiterlaserchip mit
- einem Trägersubstrat (1), das von einem Aufwachssubstrat für eine Bauelementstruktur (50) verschieden ist,
- einer als Bond-Schicht gestalteten ersten Zwischenschicht (2), über die das Trägersubstrat (1) direkt an die Bauelementstruktur (50) des kantenemittierenden Halbleiterlaserchips gebondet ist, so dass die erste Zwischenschicht (2) in direktem Kontakt zu dem Trägersubstrat (1) und der Bauelementstruktur (50) steht, wobei die Bauelementstruktur (50) eine aktiven Zone (5), umfasst, die zur Strahlungserzeugung vorgesehen ist,
- einer zweiten Zwischenschicht (2), wobei die Bauelementstruktur (50) mit der aktiven Zone (5) zwischen der ersten und der zweiten Zwischenschicht (2) angeordnet ist,
wobei die zweite Zwischenschicht (2) in direktem Kontakt zu der Bauelementstruktur (50) und zu einer Kontaktschicht (7) steht und sich an einer der Bauelementstruktur (50) abgewandten Seite der Kontaktschicht (7) ein elektrischer Kontakt (8) mit einem Kontaktmaterial befindet, wobei
- die erste Zwischenschicht (2) und die zweite Zwischenschicht (2) je eine Mantelschicht (3,30) des kantenemittierenden Halbleiterlaserchips bilden,
- die erste Zwischenschicht (2) elektrisch isolierend ist und die Bauelementstruktur (50) von dem Trägersubstrat (1) elektrisch isoliert, und
- die zweite Zwischenschicht (2) eine Bond-Schicht ist, über die die Bauelementstruktur (50) an die Kontaktschicht (7) gebondet ist.

2. Kantenemittierender Halbleiterlaserchip gemäß dem vorherigen Anspruch,
bei dem die Bauelementstruktur (50) aus einer n-seitigen Wellenleiterschicht (6), eine p-seitige Wellenleiterschicht (12) und einer aktive Zone (5) zwischen den Wellenleiterschichten (6, 12) besteht.

3. Kantenemittierender Halbleiterlaserchip gemäß einem der vorherigen Ansprüche,
bei dem die zweite Zwischenschicht (2) zumindest eines der folgenden Materialen enthält oder aus zumindest einem der folgenden Materialien besteht: ein transparentes und leitfähiges Oxid, ein Tantaloxid, ein Hafniumoxid, ein Zinkoxid.

4. Kantenemittierender Halbleiterlaserchip gemäß einem der vorherigen Ansprüche,
bei dem die Zwischenschichten (2) einen geringeren Brechungsindex aufweisen als die Bauelementstruktur (50).

5. Kantenemittierender Halbleiterlaserchip gemäß einem der vorherigen Ansprüche,
bei dem die erste Zwischenschicht (2) zumindest eines der folgenden Materialen enthält oder aus zumindest einem der folgenden Materialien besteht: ein Siliziumoxid, ein Siliziumnitrid, ein Aluminiumoxid.

## Claims

1. Edge emitting semiconductor laser chip comprising
- a carrier substrate (1), which is different from a growth substrate for a component structure (50),
- a first interlayer (2), which is configured as a bonding layer and by means of which the carrier substrate (1) is bonded directly to the component structure (50) of the edge emitting semiconductor laser chip, such that the first interlayer (2) is in direct contact with the carrier substrate (1) and the component structure (50), wherein the component structure (50) comprises an active zone (5) provided for generating radiation,
- a second interlayer (2), wherein the component structure (50) is arranged with the active zone (5) between the first and the second interlayer (2),
wherein the second interlayer (2) is in direct contact with the component structure (50) and with a contact layer (7), and an electrical contact (8) comprising a contact material is situated at a side of the contact layer (7) which is remote from the component structure (50),
where
- the first interlayer (2) and the second interlayer (2) form a respective cladding layer (3, 30) of the edge emitting semiconductor laser chip,
- the first interlayer (2) is electrically insulating and electrically insulates the component structure (50) from the carrier substrate (1) and
- the second interlayer (2) is a bonding layer, by means of which the component structure (50) is bonded to the contact layer (7).

2. Edge emitting semiconductor laser chip according to the preceding claim,
in which the component structure (50) consists of an n-side waveguide layer (6), a p-side waveguide layer (12) and an active zone (5) between the waveguide layers (6, 12).

3. Edge emitting semiconductor laser chip according to one of the preceding claims,
in which the second interlayer (2) contains at least one of the following materials or consists of at least one of the following materials: a transparent and conductive oxide, a tantalum oxide, a hafnium oxide, a zinc oxide.

4. Edge emitting semiconductor laser chip according to one of the preceding claims,
in which the interlayers have a lower refractive index than the component structure (50).

5. Edge emitting semiconductor laser chip according to one of the preceding claims,
in which the first interlayer (2) contains at least one of the following materials or consists of at least one of the following materials: a silicon oxide, a silicon nitride, an aluminium oxide.

## Revendications

1. Puce laser à semi-conducteur et émission par le chant, présentant
- un substrat de support (1) différent d'un substrat de croissance prévu pour la structure (50) d'un composant,
- une première couche intermédiaire (2) configurée sous la forme d'une couche de liaison par laquelle le substrat de support (1) est lié directement à la structure (50) du composant de la puce laser à semi-conducteur et émission par le chant de telle sorte que la première couche intermédiaire (2) soit en contact direct avec le substrat de support (1) et la structure (50) du composant, la structure (50) du composant comportant une zone active (5) prévue pour produire un rayonnement,
- une deuxième couche intermédiaire (2), la structure (50) du composant dotée de la couche active (5) étant disposée entre la première et la deuxième couche intermédiaire (2), la deuxième couche intermédiaire (2) étant en contact direct avec la structure (50) du composant et avec une couche de contact (7), un contact électrique (8) doté d'un matériau de contact étant situé sur le côté de la couche de contact (7) non tourné vers la structure (50) du composant,
dans lequel
- la première couche intermédiaire (2) et la deuxième couche intermédiaire (2) formant chacune une couche d'enveloppe (3, 30) de la puce laser à semi-conducteur et émission par le chant,
- la première couche intermédiaire (2) étant électriquement isolante et isolant électriquement la structure (50) du composant vis-à-vis du substrat de support (1),
- la deuxième couche intermédiaire (2) étant une couche de liaison par laquelle la structure (50) du composant est liée à la couche de contact (7).

2. Puce laser à semi-conducteur et émission par le chant selon la revendication précédente, dans laquelle la structure (50) du composant est constituée d'une couche (6) de guide d'onde côté n, d'une couche (12) de guide d'onde côté p et d'une zone active (5) située entre les couches (6, 12) de guide d'onde.

3. Puce laser à semi-conducteur et émission par le chant selon l'une des revendications précédentes, dans laquelle la deuxième couche intermédiaire (2) contient au moins l'un des matériaux suivants ou est constituée d'au moins l'un des matériaux suivants : un oxyde transparent et conducteur, un oxyde de tantale, un oxyde d'hafnium et un oxyde de zinc.

4. Puce laser à semi-conducteur et émission par le chant selon l'une des revendications précédentes, dans laquelle les couches intermédiaires (2) ont un indice de réfraction plus bas que la structure (50) du composant.

5. Puce laser à semi-conducteur et émission par le chant selon l'une des revendications précédentes, dans laquelle la première couche intermédiaire (2) contient au moins l'un des matériaux suivants ou est constituée d'au moins l'un des matériaux suivants : un oxyde de silicium, un nitrure de silicium et un oxyde d'aluminium.
